# DEMANDE DE BREVET EUROPEEN

(11) **EP 2 445 013 A2**
(43) Date de publication de la demande: **25.04.2012**
(21) Numéro de dépôt: 12150732.1
(22) Date de dépôt: 08.09.2008
(51) Int. Cl.: H01L 31/032, H01L 31/0392

(54) **Perfectionnements apportés à des éléments capables de collecter de la lumière**

(30) Priorité: 05.10.2007 FR 0758090
(62) Demande divisionnaire de: 08835535.9
(71) Demandeur: Saint-Gobain Glass France, 92400 Courbevoie (FR)
(72) Inventeur: Aauvray, Stéphane, 92150 SURESNES (FR); Janke, Nikolas, 52134 HERZOGENRATH (DE)
(74) Mandataire: Neuviale, Bertrand

(57) **Abrégé**

Substrat (1) à fonction verrière contenant des alcalins comprenant une première face principale destinée à être associée à une couche à base d'un matériau absorbant, notamment de type chalcopyrite, et une seconde face principale se **caractérisé en ce qu'**il comporte sur au moins une portion de surface de la seconde face principale au moins une couche barrière (9) aux alcalins.

## Description

La présente invention est relative à des perfectionnements apportés à des éléments capables de collecter de la lumière ou plus généralement à tout dispositif électronique tel qu'une cellule solaire à base de matériaux semi-conducteurs.

Il est connu que des éléments capables de collecter de la lumière du type cellules solaires photovoltaïques à couches minces comportent une couche d'agent absorbant, au moins une électrode disposée sur le côté d'incidence de la lumière à base d'un matériau métallique, et une électrode arrière à base d'un matériau métallique, cette électrode arrière pouvant être relativement épaisse et opaque. Elle doit se caractériser essentiellement par une résistance électrique de surface aussi faible que possible et une bonne adhérence à la couche d'absorbeur ainsi que le cas échéant au substrat.

Les composés ternaires chalcopyrites qui peuvent jouer le rôle d'absorbeur contiennent généralement du cuivre, de l'indium et du sélénium. Il s'agit là de ce que l'on appelle des couches d'agent absorbant CISe₂. On peut aussi ajouter à la couche d'agent absorbant du gallium (ex : Cu(In,Ga)Se₂ ou CuGaSe₂), de l'aluminium (ex : Cu(In,Al)Se₂), ou du soufre (ex : CuIn(Se,S). On les désigne en général et ci-après par le terme de couches d'agent absorbant à chalcopyrite.

Dans le cadre de cette filière d'agent absorbant à chalcopyrite, les électrodes arrière sont la plupart du temps fabriquées à base de molybdène.

Or, de hautes performances de cette filière ne peuvent être atteintes que par un contrôle rigoureux de la croissance cristalline de la couche d'agent absorbant, et de sa composition chimique.

De plus, on sait que parmi tous les facteurs qui y contribuent, la présence de sodium (Na) sur la couche de Mo est un paramètre-clé qui favorise la cristallisation des agents absorbants à chalcopyrites. Sa présence en quantité contrôlée permet de réduire la densité de défauts de l'absorbeur et d'augmenter sa conductivité.

Le substrat à fonction verrière contenant des alcalins, généralement à base de verre silico-sodo-calcique, constitue naturellement un réservoir de sodium. Sous l'effet du procédé de fabrication des couches de l'agent absorbant, généralement mis en oeuvre à haute température, les alcalins vont migrer au travers du substrat, de l'électrode arrière à base de molybdène, vers la couche d'agent absorbant, notamment de type à chalcopyrite. La couche en molybdène laisse diffuser librement le sodium du substrat vers les couches actives supérieures sous l'effet d'un recuit thermique. Cette couche de Mo présente malgré tout l'inconvénient de ne permettre qu'un contrôle partiel et peu précis de la quantité de Na qui migre à l'interface Mo/CIGSe_{2.}

Selon une variante de réalisation, la couche d'agent absorbant est déposée, à haute température, sur la couche à base de molybdène, qui est séparée du substrat à l'aide d'une couche barrière à base de nitrures, d'oxydes ou d'oxynitrures de Si, ou d'oxydes ou d'oxynitrures d'aluminium Cette couche barrière permet de bloquer la diffusion du sodium issu de la diffusion au sein du substrat vers les couches actives supérieures déposées sur le Mo.

Bien qu'ajoutant une étape supplémentaire au procédé de fabrication, cette dernière solution offre la possibilité de doser de manière très précise la quantité de Na déposée sur la couche de Mo en ayant recours à une source extérieure (ex : NaF, Na₂O₂, Na₂Se).

Le procédé de fabrication des électrodes à base de molybdène est un procédé continu qui implique que les substrats ainsi revêtus soient stockés en pile sur des chevalets avant leur utilisation ultérieure dans un procédé en reprise au cours duquel la couche à base de matériau absorbant sera déposée sur la surface de l'électrode en molybdène.

Au cours des phases de stockage des substrats dans les racks, la couche de molybdène fait donc face au substrat de verre en regard. Cette face riche en sodium est susceptible de contaminer la face de molybdène et de l'enrichir avec le temps. Ce mécanisme de dopage non contrôlé peut conduire à une dérive des procédés de fabrication lors de la phase de dépôt du molybdène en reprise.

La présente invention vise donc à pallier ces inconvénients en proposant un substrat à fonction verrière dont la diffusion du sodium est contrôlée.

A cet effet, le substrat à fonction verrière contenant des alcalins comprenant une première face principale destinée à être associée à une couche à base d'un matériau absorbant, de type à chalcopyrite et une seconde face principale se caractérise en ce qu'il comporte sur au moins une portion de surface de la seconde face principale au moins une couche barrière aux alcalins.

Dans des modes de réalisation préférés de l'invention, on peut éventuellement avoir recours en outre à l'une et/ou à l'autre des dispositions suivantes :
- il comporte sur au moins une portion de surface de la première face principale au moins une couche barrière aux alcalins.
- la couche barrière est à base d'un matériau diélectrique,
- le matériau diélectrique est à base de nitrures, d'oxydes ou d'oxynitrures de silicium, ou de nitrures, d'oxydes ou d'oxynitrures d'aluminium, utilisés seul ou en mélange,
- l'épaisseur de la couche barrière est comprise entre 3 et 200nm préférentiellement comprise entre 20 et 100nm et sensiblement voisine de 50 nm,
- la couche barrière est à base de nitrure de silicium.
- La couche à base de nitrure de silicium est sous-stoechiométrique.
- La couche à base de nitrure de silicium est sur-stoechiométrique.

Selon un autre aspect de l'invention, elle vise également un élément capable de collecter de la lumière utilisant au moins un substrat tel que précédemment décrit.

Dans des modes de réalisation préférés de l'invention, on peut éventuellement avoir recours en outre à l'une et/ou à l'autre des dispositions suivantes :
- Elément capable de collecter de la lumière, comportant un premier substrat à fonction verrière et un second substrat à fonction verrière, lesdits substrats emprisonnant entre deux couches conductrices formant les électrodes au moins une couche fonctionnelle à base d'un matériau d'agent absorbant à chalcopyrite permettant une conversion énergétique de la lumière en énergie électrique **caractérisé en ce que** l'un au moins des substrats est à base d'alcalins et comporte, sur l'une de ses faces principales, au moins une couche barrière aux alcalins.
- Au moins une portion de surface de la face principale du substrat non revêtue de la couche barrière comporte une couche conductrice à base de molybdène
- On interpose entre la couche conductrice et la face principale du substrat une couche barrière aux alcalins.
- La couche barrière aux alcalins est à base d'un matériau diélectrique
- le matériau diélectrique est à base de nitrures, d'oxydes ou d'oxynitrures de silicium, ou de nitrures, d'oxydes ou d'oxynitrures d'aluminium, utilisés seul ou en mélange,
- l'épaisseur de la couche barrière est comprise entre 3 et 200nm préférentiellement comprise entre 20 et 100nm et sensiblement voisine de 50 nm

Selon un autre aspect de l'invention, elle vise également un procédé de fabrication du substrat tel que précédemment décrit qui se caractérise en ce que la couche barrière et la couche électroconductrice ou une seconde couche barrière sont déposées à l'aide d'un procédé de pulvérisation magnétron « haut » et « bas ».

D'autres caractéristiques, détails, avantages de la présente invention apparaîtront mieux à la lecture de la description qui va suivre, faite à titre illustratif et nullement limitatif, en référence à des figures annexées sur lesquelles :
- la figure 1 est vue schématique d'un élément capable de collecter de la lumière selon l'invention,
- la figure 2 est une vue schématique d'un substrat selon un premier mode de réalisation, la couche barrière étant déposée sur la face étain dudit substrat,
- la figure 3 est une vue schématique d'un substrat selon un deuxième mode de réalisation, la couche barrière étant sur déposée sur la face air dudit substrat, à l'interface entre le verre et la couche conductrice.
- La figure 4 est un graphe montre l'évolution de la teneur en oxygène et en sodium dans la couche fonctionnelle, en fonction de différentes épaisseurs de la couche barrière

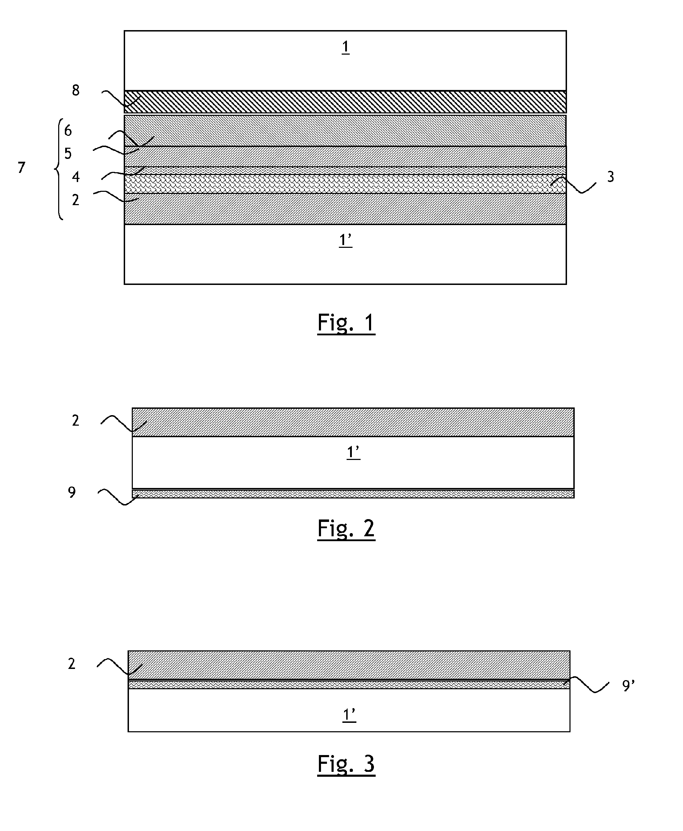

Sur la figure 1, on a représenté un élément capable de collecter de la lumière (une cellule solaire ou photovoltaïque).

Le substrat 1 transparent à fonction verrière peut par exemple être entièrement en verre contenant des alcalins comme un verre silico-sodo-calcique. Il peut également être en un polymère thermoplastique tel qu'un polyuréthane ou un polycarbonate ou un polyméthacrylate de méthyle.

L'essentiel de la masse (c'est-à-dire pour au moins 98 % en masse), voire la totalité du substrat à fonction verrière est constituée de matériau(x) présentant la meilleure transparence possible et ayant de préférence une absorption linéique inférieure à 0,01 mm⁻¹ dans la partie du spectre utile à l'application (module solaire), généralement le spectre allant de 380 à 1200 nm.

Le substrat 1 selon l'invention peut avoir une épaisseur totale allant de 0,5 à 10 mm lorsqu'on l'utilise comme plaque protectrice d'une cellule photovoltaïque de diverses technologies chalcopyrites (CIS, CIGS, CIGSe₂...) ou en tant que substrat support 1' destiné à recevoir l'ensemble de l'empilement fonctionnel. Lorsque le substrat 1 est utilisé comme plaque protectrice, il peut être avantageux de faire subir à cette plaque un traitement thermique (du type trempe par exemple) lorsqu'il est en verre.

De manière conventionnelle, on définit par A la face avant du substrat dirigée vers les rayons lumineux (il s'agit de la face externe), et par B la face arrière du substrat dirigée vers le reste des couches du module solaire (il s'agit de la face interne).

La face B du substrat 1' est revêtue d'une couche première couche conductrice 2 devant servir d'électrode. Sur cette électrode 2 est déposée la couche fonctionnelle 3 à base d'agent absorbant à chalcopyrite. Lorsqu'il s'agit d'une couche fonctionnelle 3 à base par exemple de CIS, CIGS, ou CIGSe₂ il est préférable que l'interface entre la couche fonctionnelle 3 et l'électrode 2 soit à base de molybdène. Une couche conductrice répondant à ces exigences est décrite dans la demande de brevet européen EP1356528.

La couche d'agent absorbant à chalcopyrite 3 est revêtue d'une fine couche 4 en sulfure de cadnium (CdS) permettant de créer avec la couche à chalcopyrite 3 une jonction pn. En effet, l'agent chalcopyrite est généralement dopé n, la couche 4 en CdS étant dopée p, cela permet de créer la jonction pn nécessaire à l'établissement d'un courant électrique.

Cette fine couche 4 de CdS est elle-même recouverte d'une couche d'accrochage 5 généralement formée d'oxyde de zinc dit intrinsèque (ZnO : i).

Afin de former la seconde électrode, la couche de ZnO :i 5 est recouverte d'une couche 6 en TCO pour « Transparent Conductive Oxide ». Elle peut être choisie parmi les matériaux suivants : oxyde d'étain dopé, notamment en fluor ou à l'antimoine (les précurseurs utilisables en cas de dépôt par CVD peuvent être des organo-métalliques ou halogénures d'étain associés avec un précurseur de fluor du type acide fluorhydrique ou acide trifluoracétique), l'oxyde de zinc dopé, notamment à l'aluminium (les précurseurs utilisables, en cas de dépôt par CVD, peuvent être des organo-métalliques ou halogénures de zinc et d'aluminium), ou encore l'oxyde d'indium dopé, notamment à l'étain (les précurseurs utilisables en cas de dépôt par CVD peuvent être des organo-métalliques ou halogénures d'étain et d'indium). Cette couche conductrice doit être aussi transparente que possible, et présenter une transmission élevée de la lumière dans l'ensemble des longueurs d'onde correspondant au spectre d'absorption du matériau constituant la couche fonctionnelle, afin de ne pas réduire inutilement le rendement du module solaire.

On a constaté que la couche relativement mince 5 (par exemple 100 nm) en ZnO diélectrique (ZnO :i) entre la couche fonctionnelle 3 et la couche conductrice dopé n, par exemple en CdS , influençait de façon positive la stabilité du procédé de dépôt de la couche fonctionnelle.
La couche conductrice 6 présente résistance par carré d'au plus 30 ohms/carré, notamment d'au plus 20 ohms/carré, de préférence d'au plus 10 ou 15 ohms/carré. Elle est généralement comprise entre 5 et 12 ohms/carré.

L'empilement 7 de couches minces est emprisonné entre deux substrats 1 et 1' par l'intermédiaire d'un intercalaire de feuilletage 8 par exemple en PU, PVB ou EVA. Le substrat 1' se distingue du substrat 1 par le fait qu'il est nécessairement en verre, à base d'alcalins (pour des raisons qui ont été explicitées dans le préambule de l'invention), comme un verre silico-sodo-calcique de manière à conformer une cellule solaire ou photovoltaïque puis encapsulé périphériquement à l'aide d'un joint ou d'une résine d'étanchéité. Un exemple de composition de cette résine et de ses modalités de mise en oeuvre est décrit dans la demande EP739042.

Selon une caractéristique avantageuse de l'invention (se reporter en figure 2), on prévoit de déposer sur toute ou partie de la face du substrat 1' (par exemple au niveau de la face étain) qui n'est pas en contact avec la couche électroconductrice 2, notamment à base de molybdène, une couche 9 barrière aux alcalins. Cette couche barrière 9 aux alcalins est à base d'un matériau diélectrique, ce matériau diélectrique étant à base de nitrures, d'oxydes ou d'oxynitrures de silicium, ou de nitrures, d'oxydes ou d'oxynitrures d'aluminium, utilisés seul ou en mélange. L'épaisseur de la couche barrière 9 est comprise entre 3 et 200nm préférentiellement comprise entre 20 et 100nm et sensiblement voisine de 50 nm.

Cette couche barrière aux alcalins, par exemple, à base de nitrure de silicium, peut ne pas être stoechiométrique. Elle peut être de nature sous-stoechiométrique, voire et de manière préférée sur-stoechiométrique. Par exemple cette couche est du SiₓN_{y}, avec un rapport x/y d'au moins 0.76, préférentiellement compris entre 0.80 et 0.90, car il a été démontré que lorsque SiₓN_{y} est riche en Si, l'effet barrière aux alcalins est d'autant plus efficace.

La présence de cette couche barrière en face arrière du substrat 1' permet d'éviter la pollution de la couche conductrice 2 à base de Mo au cours des étapes de stockage (entre production et utilisation), lorsqu'elle est en contact avec la face de verre en regard. Elle apporte également une solution simple pour bloquer le mécanisme d'éjection du Na de la face arrière du verre induit par les étapes de recuit/ sélénisation au cours desquelles les bâtis de production risquent d'être contaminés causant ainsi la dérive des procédés de fabrication.

Selon une variante de réalisation (se reporter en figure 3), on prévoit d'insérer une couche barrière 9' aux alcalins similaire à la précédente entre le substrat 1' à base d'alcalin et la couche conductrice 2 à base de Mo. Là encore, elle peut être constituée de nitrures, d'oxydes ou d'oxynitrures de Si, ou d'oxydes ou d'oxynitrures d'aluminium. Elle permet de bloquer la diffusion du Na, du verre vers les couches actives supérieures déposées sur le Mo. Bien qu'ajoutant une étape supplémentaire au procédé de fabrication, cette dernière solution offre la possibilité de doser de manière très précise la quantité de Na déposée sur la couche de Mo en ayant recours à une source extérieure (ex : NaF, Na₂O₂, Na₂Se). L'épaisseur de la couche barrière est comprise entre 3 et 200nm préférentiellement comprise entre 20 et 100nm et sensiblement voisine de 50 nm

La couche barrière 9 située en face arrière du substrat 1' (en général côté face étain du substrat) est déposée avant ou après le dépôt des empilements à base de Molybdène, par pulvérisation magnétron de type sputter down ou sputter up. Un exemple de ce procédé de réalisation est donné par exemple dans le brevet EP 1179 516. La couche barrière peut également être déposée par les procédés CVD comme la PE-CVD (Plasma Enhanced Chemical Vapor Deposition).

Parmi toutes les combinaisons possibles, la solution la plus simple est un procédé en une seule étape, l'ensemble des couches est déposé dans le même coater.

Dans ce cas, la couche barrière à base de diélectrique (par exemple du nitrure de silicium) est déposée sur la face arrière par pulvérisation magnétron de type sputter up ou « pulvérisation par le haut », tandis que les couches à base matériau conducteur, par exemple du Mo et/ou l'autre couche barrière 9' en matériau diélectrique située à l'interface verre (face air) et la couche conductrice 2, par exemple à base de molybdène, sont ensuite ajoutées sur la face air par pulvérisation magnétron de type sputter down ou « pulvérisation par le haut ».

Une autre solution consiste à utiliser un procédé en deux étapes séparées où l'ensemble des couches est déposé par pulvérisation magnétron de type sputter down. Dans ce cas, pour éviter toute contamination de la couche de Mo, il est préférable de déposer au préalable la couche barrière sur la face arrière (à savoir côté face étain du substrat). Entre les deux étapes de dépôt, la pile de substrats doit être manipulée pour être retournée.

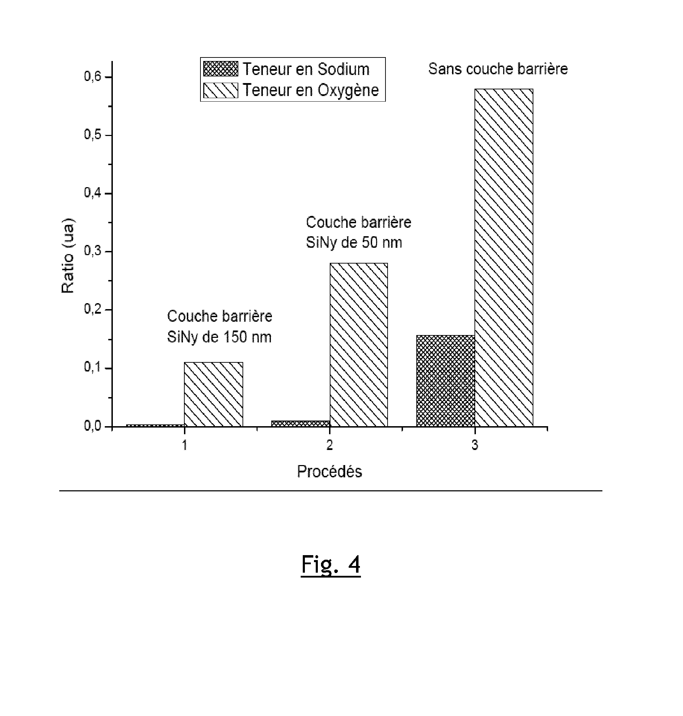

Quel que soit le procédé de fabrication, en se référant à la figure 4, on remarque que sans couche barrière notamment en SiN les teneurs en O et en Na sont respectivement 20 fois et 5 fois plus grandes qu'avec une couche de 150 nm de SiN. On voit également qu'une épaisseur de 50 nm de SiN permet de réduire significativement la diffusion de Na (d'un facteur 15 environ) mais que son étanchéité vis-à-vis de la diffusion d'oxygène est limitée (facteur 2 environ). Pour stopper efficacement la migration du Na ou de l'oxygène du verre vers l'extérieur on voit donc qu'une couche de 150 nm de SiN remplit parfaitement la fonction. L'application d'une telle couche est particulièrement intéressante pendant les phases de stockage pour éviter la contamination de la face en regard (oxydation de la surface ou enrichissement en Na).

Ce type de couche est intéressant pour éviter la dérive des process de sélénisation susceptible de réagir avec la Na pendant la fabrication des modules.

Un module solaire tel que précédemment décrit, doit, pour pouvoir fonctionner et délivrer une tension électrique à un réseau de distribution électrique, être d'une part, pourvu de dispositifs de connexions électriques et d'autre part, pourvu de moyens de support et de solidarisation assurant son orientation par rapport au rayonnement lumineux.

## Revendications

1. Substrat (1, 1') à fonction verrière contenant des alcalins comprenant une première face principale destinée à être associée à une couche à base d'un matériau absorbant, de type chalcopyrite, et une seconde face principale, au moins une portion de surface de la première face principale du substrat (1') comportant une couche conductrice (2) à base de molybdène, **caractérisé en ce qu'**il comporte sur au moins une portion de surface de la seconde face principale au moins une couche barrière (9) aux alcalins à base de nitrure de silicium.

2. Substrat selon la revendication 1, **caractérisé en ce qu'**il comporte sur au moins une portion de surface de la première face principale au moins une couche barrière (9') aux alcalins.

3. Substrat selon la revendication 2, **caractérisé en ce que** la couche barrière (9') est à base d'un matériau diélectrique.

4. Substrat selon la revendication 3, **caractérisé en ce que** le matériau diélectrique est à base de nitrures, d'oxydes ou d'oxynitrures de silicium, ou de nitrures, d'oxydes ou d'oxynitrures d'aluminium, utilisés seul ou en mélange.

5. Substrat selon l'une des revendications précédentes, **caractérisé en ce que** la couche à base de nitrure de silicium (9) de la seconde face principale est sous-stoechiométrique.

6. Substrat selon l'une des revendications 1 à 4, **caractérisé en ce que** la couche à base de nitrure de silicium (9) de la seconde face principale est sur-stoechiométrique.

7. Substrat selon l'une des revendications précédentes, **caractérisé en ce que** l'épaisseur de la couche barrière (9) est comprise entre 3 et 200nm préférentiellement comprise entre 20 et 100nm et sensiblement voisine de 50 nm.

8. Pile de substrats, les substrats étant selon l'une quelconque des revendications précédentes, la couche conductrice (2) à base de molybdène d'un premier substrat (1') étant en contact avec ladite au moins une couche barrière (9) aux alcalins portée par la seconde face principale d'un second substrat (1').

9. Elément capable de collecter de la lumière utilisant au moins un substrat selon quelconques des revendications précédentes.

10. Elément capable de collecter de la lumière selon la revendication 9, comportant un premier substrat (1) à fonction verrière et un second substrat (1') à fonction verrière, lesdits substrats emprisonnant entre deux couches conductrices (2, 6) formant les électrodes au moins une couche fonctionnelle (3) à base d'un matériau d'agent absorbant, de type à chalcopyrite permettant une conversion énergétique de la lumière en énergie électrique **caractérisé en ce que** l'un au moins des substrats (1, 1') est selon l'une quelconque des revendications 1 à 6.

11. Procédé de fabrication d'un substrat utilisé dans un élément selon la revendication 10, **caractérisé en ce que** la couche barrière (9) et la couche électroconductrice à base de molybdène (2) sont déposées à l'aide d'un procédé de pulvérisation magnétron « haut » et « bas ».
